# EUROPEAN PATENT APPLICATION

(11) **EP 2 654 203 A1**
(43) Date of publication of application: **23.10.2013**
(21) Application number: 12305459.5
(22) Date of filing: 20.04.2012
(51) Int. Cl.: H03F 1/02

(54) **An amplifier circuit, a method, and a computer program for amplifying a modulated radio-frequency signal**

(71) Applicant: Alcatel Lucent, 75007 Paris (FR)
(72) Inventor: Moretto, Maurizio, 20060 Mediglia (MI) (IT)
(74) Representative: 2SPL Patentanwälte

(57) **Abstract**

An amplifier circuit (100) according to an embodiment for amplifying a modulated radio-frequency signal (RF) comprising a radio-frequency component and an envelope component comprises an amplifying circuit (110) operable to amplify the radio-frequency signal (RF), a power supply circuit (120) coupled to the amplifying circuit (110) to provide a power supply signal to the amplifying circuit (110), and an inductive circuit element (130) coupled between the amplifying circuit (110) and the power supply circuit (120), wherein the power supply circuit (120) is operable to provide the power supply signal based on the envelope component and a suppressed radio-frequency component. The amplifier circuit (100) according to an embodiment may improve an energy efficiency.

## Description

Embodiments relate to an amplifying circuit for amplifying a modulated radio-frequency signal, a method for amplifying a modulated radio-frequency signal and a computer program comprising a program code for performing such a method.

### Background

Amplifier circuits for radio-frequency signals are used in a vast number of technical fields and applications. Among those fields are, for instance, commercial, industrial, research, medical, and military applications. Amplifier circuits are, for instance, widely used as central components of driver applications.

More specifically, amplifier circuits for radio-frequency signals are used in the framework of test or measurement equipment to determine characteristics of a device under test or to measure medical conditions of a patient to name only a few examples. They are also widely used in the field of telecommunications and radio-based detection (e.g. radar). Here, radio-frequency amplifier circuits are, for instance, used to receive or to transmit pulses, encoded data, speech, pictures or other pieces of information.

In many of these applications, power consumption and energy efficiency may be an essential parameter for a number of reasons. Energy efficiency and power consumption, for instance, directly influences thermal properties of the amplifier. Moreover, in mobile applications or other applications, in which the total amount of energy available is limited, an operational period may be affected. As a consequence, improving an efficiency of linear power amplifiers has been addressed many times in the past in all fields, in which signal amplification is required.

While many solutions have been found in the low-frequency end of the signal spectrum, such as class D amplifiers for audio-related applications, for the specific case of microwave power amplifiers and/or radio-frequency power amplifiers with very wideband modulating signals a fully satisfactory solution has not been found yet. Conventional solutions may still leave room for improvements.

The European patent application EP 0 926 815 A1 relates to a high-efficiency low-distortion linear power amplifier circuit for signals having a high peak power to mean power ratio and the corresponding method for driving it. However, the linear power amplifier circuit described in the document does not provide any method for controlling the exact amount of current flowing through its inductor. As a consequence, the linear power amplifier circuit does not adapt to varying signal level conditions, which might lead to a loss of efficiency.

### Summary

Therefore, a demand exists to improve an energy efficiency of an amplifier circuit for amplifying a modulated radio-frequency signal.

An amplifier circuit according to the embodiment for amplifying a modulated radio-frequency signal comprising a radio-frequency component and an envelope component comprises an amplifying circuit operable to amplify the radio-frequency signal. It further comprises a power supply circuit coupled to the amplifying circuit to provide a power supply signal to the amplifying circuit and an inductive circuit element coupled between the amplifying circuit and a power supply circuit. The power supply circuit is operable to provide the power supply signal based on the envelope component and a suppressed radio-frequency component.

A method according to an embodiment for amplifying a modulated radio-frequency signal comprising a radio-frequency component and an envelope component comprises providing a power supply signal via an inductive circuit element, wherein the power supply signal is based on the envelope component and a suppressed radio-frequency component of the modulated radio-frequency signal. It further comprises amplifying the radio-frequency signal using the power supply signal.

Embodiments are based on the finding that an energy efficiency of an amplifier circuit can be improved by providing the power supply signal via an inductive circuit element to the amplifying circuit taking the envelope component into consideration. Through this, it becomes possible to adapt a strength of the power supply signal more accurately to a demand of the amplifying circuit without sacrifice the possibilities and implementation of the inductive circuit element.

Depending on the concrete implementation of the inductive circuit element, it may not only provide electrical decoupling of the power supply circuit from the radio-frequency component of the radio-frequency signal or a radio-frequency component of the amplified radio-frequency signal provided by the amplifying circuit. It may further provide the opportunity of temporarily storing and releasing energy to the amplifying circuit to compensate a short-time additional demand caused by the actual shape of the radio-frequency signal to be amplified.

The inductive circuit element may, for instance, be implemented as at least one of an inductor, a radio-frequency choke, a ferrite component, a passive electrical circuit, an active electrical circuit, and a gyrator-based inductive circuit. A strength of a signal may be, depending on the concrete implementation of an embodiment, a power, an amplitude, a voltage level or a current level of the respective signal.

In an embodiment of an amplifier circuit, the power supply circuit may be operable to provide the power supply signal based on an average of the envelope component. This may provide the opportunity to simplify the implementation of the power supply circuit, since the frequencies involved may be reduced. In some embodiments, a short-time average may be used. In other words, the power supply circuit may be operable such that it tracks a short-time average of the envelope component of the modulated radio-frequency signal.

Accordingly, in an amplifier circuit according to an embodiment, the power supply circuit may be operable to provide the power supply signal based on a short-time average of the envelope component with a time-bandwidth product in the range of 10² to 10⁶. In other words, a power supply circuit may be operable to provide the power supply signal based on frequency components of the envelope component which may be several orders of magnitudes smaller than the highest frequencies of the respective envelope component. In another embodiment, the time-bandwidth-product may be between 10³ and 10⁵, sometimes even between 3·10³ and 4·10⁴.

In an amplifying circuit according to an embodiment, the power supply circuit may comprise a controllable power supply circuit operable to provide the power supply signal in response to a control signal. The power supply circuit may further comprise a low-pass filter operable to receive an envelope signal indicative of the envelope component, wherein the low-pass filter is further operable to provide the controlled signal by low-pass filtering the envelope signal. Employing a low-pass filter may provide the possibility of efficiently implementing the circuit capable of providing the average of the envelope component or the short-time average of the envelope component. A cut-off frequency of the low-pass filter corresponds to an inverse time or time duration over which the power supply circuit takes the average or the short-time average of the envelope component.

In such an amplifier circuit according to an embodiment, the low-pass filter may comprise a serious connection of a resistor and a capacitor. The envelope signal may be provided to the resistor and the control signal may be obtained at a node between the resistor and the capacitor. Such an implementation may offer the possibility of being easily integrated into an embodiment. Additionally or alternatively, it may also provide the possibility of limiting losses and reducing disturbances (e.g. stray capacitances).

In such an amplifier circuit according to an embodiment, the controllable power supply circuit may comprise at least one of a switched-mode power supply circuit, a DC/DC-converter, and a step-down converter. Hereby, it may be possible to implement a reliable and easily integrable power supply circuit to the amplifier circuit according to an embodiment.

In an amplifier circuit according to an embodiment, the power supply circuit may be operable to provide the power supply signal as a continuous signal or a continuously valued signal. In other words, the power supply circuit may provide the power supply signal in an analog fashion such that a strength of the power supply signal may be continuously variable. In yet other words, the power supply circuit may be implemented in contrast to a power supply circuit only capable of providing a discrete signal.

In an amplifier circuit according to an embodiment comprising the controllable power supply circuit, the power supply circuit may be operable to add a bias signal to the control signal. The controllable power supply circuit may then be operable to control a strength of the power supply signal in response to the bias signal. Depending on the concrete implementation, the strength may be a power, an amplitude, a voltage level or a current level of the respective signal.

In such an amplifier circuit according to an embodiment, the strength of the power supply signal may be a current level of the power supply signal. The bias signal may then comprise an offset control voltage level. The power supply circuit may then comprise an output resistor coupled between an output of the controllable power supply circuit and the inductive circuit element, wherein the resistor comprises a resistance value such that the controllable power supply circuit is operable to provide a pre-defined current level of the power supply signal based on a ratio of the offset control voltage level and the resistance value of the output resistor. In other words, by integrating the output resistor in the described manner and by providing the control signal with the offset control voltage level, the actual (average) of the current level provided by the power supply circuit via the inductive circuit element to the amplifying circuit may be definable and controllable.

An amplifier circuit according to an embodiment may further comprise a further power supply circuit, which may be coupled to the amplifying circuit. The further power supply circuit may be operable to provide a further power supply signal to the amplifying circuit based on the envelope component. In other words, the further power supply circuit may use the envelope component in an unfiltered, unaltered or in terms of its bandwidth limited way. For instance, the further power supply circuit may be directly coupled to an output of an envelope detector to receive the envelope signal provided by the envelope detector. This may enable the amplifier circuit to draw a major portion of the energy required by the amplifying circuit from the power supply circuit, while only a smaller fraction of the required energy is provided by the further power supply circuit. As a consequence, implementation requirements on the further power supply circuit may be eased. For instance, stray capacitances of the further power supply circuit can eventually be reduced, since a probability of larger amounts of energy drawn from the further power supply circuit may be reduced. Hence, components of the further power supply circuit may be designed to be less capable of handling high currents, which might reduce their frequency response and their bandwidth. As a consequence, the further power supply circuit may comprise components that can be designed to provide a higher bandwidth.

For instance, in an amplifier circuit according to an embodiment, the further power supply circuit and the power supply circuit may be operable to provide on average a strength of the further power supply signal and of the power supply signal, respectively, comprising a ratio of not more than 30:70. Depending on the expected shape of the envelope component and further parameters, it may even be possible to design the power supply circuit and the further power supply circuit such that the previously mentioned ratio does not exceed 20:80, 10:90, 5:95, or 1:99.

An amplifier circuit according to an embodiment comprising a further power supply circuit may further comprise a feedback control circuit operable to detect a strength of the further power supply signal and to provide a bias adjust signal to the power supply circuit in response to a time-average of the detected strength of the further power supply signal. The power supply circuit may then comprise a controllable power supply circuit operable to provide the power supply signal in response to a control signal, wherein the power supply circuit is operable to add the bias adjust signal to the control signal. By implementing the feedback control circuit, it may therefore be possible to even more closely monitor the actual strength of the further power supply signal drawn from the further power supply circuit. In response to the detected strength of the further power supply signal, the strength of the power supply signal provided by the power supply circuit may be adjusted accordingly. Therefore, the feedback control circuit may provide a possibility of even further adjusting the power supply signal to compensate for, for instance, different modes of operation of the amplifier circuit or its surrounding components, aging effects and other changes of parameters of components of the amplifier circuit or its surrounding components or other effects, such as signal-related effects.

Such an amplifier circuit, the feedback control circuit may be operable to provide the bias adjust signal based on an averaging time between 0.01 s and 100 s. In other words, not only compared to typical frequencies of the radio-frequency signal, but also to its envelope component and the short-time average of the envelope component provided to the power supply circuit, the feedback control circuit enables a compensation of drifts occurring on longer time scales. In other embodiments, the averaging time may be between 0.1 s and 10 s or 0.3 s and 4 s.

An amplifier circuit according to an embodiment may be a microwave amplifier circuit. Accordingly, the amplifying circuit may be a microwave amplifying circuit operable to amplify microwave signals. Microwave signals are typically radio-frequency signals having frequencies in the range between 300 MHz to 300 GHz. However, in implementation-specific cases, such as mobile communication applications, the frequency range may be smaller. For instance, in mobile communication systems, the frequencies may be in the range between 400 MHz and 5 GHz. In other systems, such as radio relay systems, or systems employing microwave links, different frequencies may be employed, for instance, frequencies in a range between 1 GHz and 50 GHz.

An amplifier circuit according to an embodiment may further comprise an envelope detector operable to provide an envelope signal indicative of the envelope component of the radio-frequency signal. Moreover, an amplifier circuit according to an embodiment may further comprise an up-converter which may be coupled to a local oscillator and operable to receive an intermediate frequency signal at an input and to provide the radio-frequency signal at an output in response to the intermediate frequency signal and a signal of the local oscillator. The up-converter may comprise a frequency mixer. The amplifier circuit may further comprise one or more filter elements operable to suppress a frequency or a frequency band in the intermediate signal or the radio-frequency signal provided by the up-converter, a delay line to compensate different delays between the intermediate frequency signals, the radio-frequency signal and the previously mentioned envelope signal, if necessary or advisable. The envelope detector may be provided with the intermediate frequency signal or the radio-frequency signal on the basis of which it is operable to provide the envelope signal comprising the information concerning the envelope component. Depending on the concrete implementation, the envelope detector or the amplifier circuit may further comprise a decoupler to electrically decouple a branch of the amplifier circuit comprising the envelope detector from a signal path of the intermediate frequency signal and/or the radio-frequency signal, for instance, to avoid disturbances, interferences or interactions with signals in the respective branches or paths of the amplifier circuit. An amplifier circuit according to an embodiment may further comprise an additional pre-amplifier to pre-amplify the radio-frequency signal provided to the power amplifying circuit.

Some embodiments comprise a digital control circuit installed within the apparatus for performing the method. Such a digital control circuit, e.g. a digital signal processor (DSP), needs to be programmed accordingly. Hence, yet further embodiments also provide a computer program having a program code for performing embodiments of the method, when the computer program is executed on a computer or a digital processor.

### Brief description of the Figures

Some embodiments of apparatuses and/or methods will be described in the following by way of example only, and with reference to the accompanying figures.
- Fig. 1: shows a simplified block diagram of an amplifier circuit according to an embodiment;
- Fig. 2: shows a circuit diagram of a part of the reference implementation of a conventional amplifier circuit;
- Fig. 3: shows a circuit diagram of a part of the amplifier circuit according to an embodiment of Fig. 1; and
- Fig.4: shows a flow chart of a method according to an embodiment.

### Description of Embodiments

Various example embodiments will now be described more fully with reference to the accompanying drawings in which some example embodiments are illustrated. In the figures, the thicknesses of lines, layers and/or regions may be exaggerated for clarity.

Accordingly, while example embodiments are capable of various modifications and alternative forms, embodiments thereof are shown by way of example in the figures and will herein be described in detail. It should be understood, however, that there is no intent to limit example embodiments to the particular forms disclosed, but on the contrary, example embodiments are to cover all modifications, equivalents, and alternatives falling within the scope of the invention. Like numbers refer to like or similar elements throughout the description of the figures.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (e.g., "between" versus "directly between," "adjacent" versus "directly adjacent," etc.).

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises," "comprising," "includes" and/or "including," when used herein, specify the presence of stated features, integers, steps, operations, elements and/or components, but do not preclude the presence or addition of one or more other features, integers, steps, operations, elements, components and/or groups thereof.

Unless otherwise defined, all terms (including technical and scientific terms) used herein have the same meaning as commonly understood by one of ordinary skill in the art to which example embodiments belong. It will be further understood that terms, e.g., those defined in commonly used dictionaries, should be interpreted as having a meaning that is consistent with their meaning in the context of the relevant art and will not be interpreted in an idealized or overly formal sense unless expressly so defined herein.

In the following, embodiments will be described in more detail. In this context, summarizing reference signs will be used to describe several objects simultaneously or to describe common features, dimensions, characteristics, or the like of these objects. The summarizing reference signs are based on their individual reference signs. Moreover, objects appearing in several embodiments or several figures, but which are identical or at least similar in terms of at least some of their functions or structural features, will be denoted with the same or similar reference signs. To avoid unnecessary repetitions, parts of the description referring to such objects also relate to the corresponding objects of the different embodiments or the different figures, unless explicitly or - taking the context of the description and the figures into account - implicitly stated otherwise. Therefore, similar or related objects may be implemented with at least some identical or similar features, dimensions, and characteristics, but may be also implemented with differing properties.

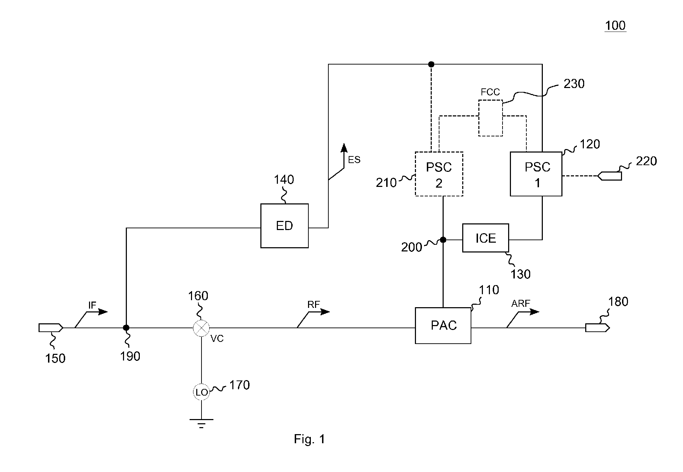

Fig. 1 shows a simplified block diagram of an amplifier circuit 100 according to an embodiment. The amplifier circuit 100 comprises an amplifying circuit (PAC) 110, a power supply circuit (PSC 1) 120 and an inductive circuit element (ICE) 130. The power supply circuit 120 is coupled via the inductive circuit element 130 to an input of the amplifying circuit 110 to be provided at least partially with energy to enable the amplifying circuit to amplify a radio-frequency signal. To facilitate this, power supply circuit 120 provides a respective output, a power supply signal based on an envelope component of the radio-frequency signal (RF). Apart from the envelope component, the radio-frequency signal RF further comprises a radio-frequency component.

To be able to provide the amplifying circuit with a power supply signal depending on the envelope component of the radio-frequency signal RF, an input of the power supply circuit 120 is coupled to an envelope detector (ED) 140 which is operable to provide an envelope signal ES comprising information concerning the envelope component of the radio-frequency signal RF.

To enable the envelope detector 140 to provide the power supply circuit 120 with the envelope signal ES, in the embodiment shown in Fig. 1, an input of the envelope detector 140 is coupled to an input terminal for an intermediate frequency signal IF provided to the amplifier circuit 100. The input terminal 150 is further coupled to an up-converter (UC) 160 which is operable to transfer the intermediate frequency signal IF into a different frequency band. To be more precise, the up-converter 160 implemented in the amplifier circuit 100 as shown in Fig. 1 comprises a frequency mixer which is operable to provide at an output the radio-frequency signal RF by mixing the intermediate frequency signal IF with an output signal of a local oscillator (LO) 170. The radio-frequency signal RF provided by the up-converter 160 is then provided to an input of the power amplifying circuit 110. An output of the power amplifying circuit 110 is coupled to an output terminal 180 of the amplifier circuit 100.

As a consequence, the amplifier circuit 100 comprises an intermediate frequency/radio-frequency path comprising, for instance, the up-converter 160, and a further branch comprising the envelope detector 140 as well as the power supply circuit 120 and the inductive circuit element 130. The intermediate frequency/radio-frequency path and the further branch comprising the envelope detector 140, which is also referred to as the envelope signal branch, are interconnected at a common node 190, connecting the input terminal 150 and the up-converter 160 as well as the envelope detector 140. The envelope signal branch and the intermediate frequency/radio-frequency path are further interconnected at the amplifying circuit 110 to which both, the radio-frequency signal and the power supply signal provided by the power supply circuit 120 are provided. The amplifying circuit 110 provides an amplified radio-frequency signal ARF to the output terminal 180.

To electrically decouple the envelope branch from the intermediate frequency/radio-frequency path, the amplifier circuit 100 may further comprise an optional decoupling element, for instance, an operational amplifier, which may be implemented as an optional component or as part of another component, for instance, the envelope detector 140.

Naturally, the circuitry shown in Fig. 1 merely represents an embodiment of an amplifier circuit 100. For instance, the envelope detector 140 may be implemented differently, just to mention one design alternative. In a different embodiment of an amplifier circuit 100, the envelope detector 140 may be coupled to an output of the up-converter 160 and, hence, be operable to receive the radio-frequency signal RF instead of the intermediate frequency signal IF. As a consequence, the node 190 may be moved behind the up-converter 160. In this case, the envelope detector 140 is operable to derive the envelope signal ES based on the radio-frequency signal RF instead of the intermediate frequency signal IF as shown in Fig. 1.

However, instead of "moving" the envelope detector 140 up in terms of frequency, the envelope detector 140 may be also coupled to receive its input signal in a frequency band with a lower corner frequency, for instance, in the baseband or in an "intermediate frequency band" with a center or corner frequency of 0 Hz. In other words, the envelope detector 140 may be operable to receive the envelope component and, as a consequence, to provide information concerning the envelope component in any frequency band, e.g. the baseband, an intermediate frequency band or a radio frequency band. The envelope detector 140 may receive its input signal, therefore, as an analog or a digital signal, to name just two examples. For instance, the envelope detector 140 may be implemented as a part of a digital modulator. The signal to be transmitted and, hence, to be amplified may be a digital signal when it is provided to the envelope detector 140 in such an embodiment.

Furthermore, in different embodiments of an amplifier circuit 100, further amplifier or amplifying stages may be implemented. For instance, between the up-converter 160 and the amplifying circuit 110, a further or additional pre-amplifier may be implemented to increase a signal level of the radio-frequency signal RF before providing same to the amplifying circuit 110.

As indicated earlier, the power supply circuit 120 is coupled via the inductive circuit element 130 to the amplifying circuit 110. The inductive circuit element 130 may, for instance, comprise an inductor, a radio-frequency choke (RF choke), a ferrite component, or a passive or active circuit, such as a gyrator-based inductive circuit, or a combination of any of the previously mentioned. By providing the power supply signal of the power supply circuit 120 via the inductive circuit element 130 to the amplifying circuit 110, it may be possible to electrically decouple the power supply circuit 120 from frequency components from the envelope signal ES and the radio-frequency signal RF at a further node 200 between the inductive circuit element 130 and input of the amplifying circuit 110 for the power supply signal. Moreover, depending on the implementation of the inductive circuit element 130, energy stored inductive circuit element 130 may be used to compensate an additional short-time demand of the amplifying circuit 110.

Using the power supply circuit 120 capable of providing the power supply signal based on the envelope signal ES or - in other words - based on the envelope component of the radio-frequency signal RF, an overall energy efficiency of the amplifier circuit 100 may be improved. For instance, it may be possible to provide the power supply signal in such a way that it tracks a short-term average of the envelope component of the radio-frequency signal. By that it may be possible to automatically adapt a strength of the power supply signal provided by the power supply circuit 120 to an energy demand of the amplifying circuit 110. Different energy demands of the amplifying circuit 110 can be caused, for instance, by different modes of operation of the amplifier circuit 100, the actual shape and the mean level of the radio-frequency signal RF, or its envelope component.

To improve the energy efficiency of the amplifier circuit 100 or to simplify the implementation of the power supply circuit 120, it may be possible to implement the power supply circuit 120 such that it provides the power supply signal based on an average of the envelope component or - in other words - based on the envelope signal ES. The average may be, for instance, a short-time average with a time-bandwidth-product between 10³ and 10⁶. In different embodiments, it may be possible to use time-bandwidth-products in the range between 10³ and 10⁵ or even between 3·10³ and 4·10⁴.

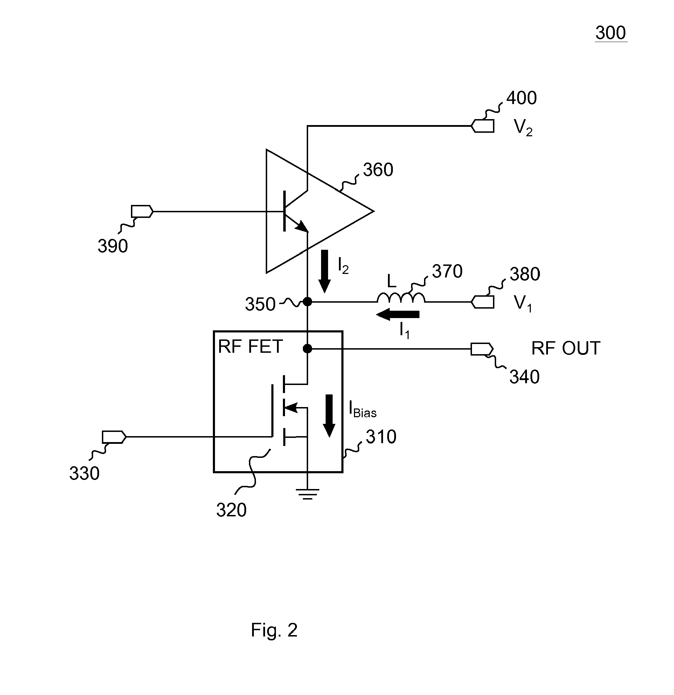

For instance, the envelope component and, hence, the envelope signal ES may comprise the frequency component of up to 100 MHz, while the power supply signal as provided by the power supply circuit 120 only comprises frequencies of 10 kHz or less. As will be shown in more detail in the context of Fig. 2, the power supply circuit may comprise a low-pass filter and a controllable power supply circuit to realize the previously mentioned short-time averages of the envelope component. In terms of a low-pass filter, the time or time period is essentially inverse proportional to a cut-off frequency of a low-pass filter.

As mentioned before, the power supply circuit 120 may be adapted such that it tracks a short-time average of the envelope component of the radio-frequency signal RF. To enable this, it may be advisable to implement the power supply circuit 120 in such a way that it provides the power supply signal as a continuous signal or a continuously valued signal. In other words, the power supply signal may be an analog signal that varies continuously in contrast to a discrete signal.

Depending on the application in mind, the concrete implementation of the amplifier circuit 100 and further parameters, it may be possible to improve the energy efficiency of the amplifier circuit 100 by further including a further power supply circuit (PSC2) 210, an output of which is also coupled to the further node 200 and, hence, to the input of the amplifying circuit 110 to which the power supply signal of the power supply circuit 120 is provided. The further power supply circuit 210 may be also coupled to an output of the envelope detector 140 to receive the envelope signal ES indicative of the envelope component of the radio-frequency signal RF. Based on the envelope component or - in other words - based on the envelope signal ES, the further power supply circuit 210 may provide a further power supply signal to the amplifying circuit 110. In contrast to the power supply circuit 120, the further power supply signal provided by the further power supply circuit 210 may be provided based on an unfiltered, unaltered or unrestricted envelope signal in terms of its bandwidth. As shown in Fig. 1, the further power supply circuit 210 is directly coupled to the envelope detector 140 to receive envelope signal ES unaltered terms of its frequency components. As a consequence, the further power signal provided by the further power supply circuit 210 may be used to compensate changes of the shape of the radio-frequency signal RF on a shorter time scale than variations of the power supply signal of power supply circuit 120. Providing the further power supply circuit 210 may therefore enable the amplifying circuit 100 to even more closely track an energy demand of the amplifying circuit 110.

By implementing the power supply circuit 120 and the further power supply circuit 210, it may be possible to provide the power supply signal and the further power supply signal not only with different response times in terms of frequency components, but it may be also possible to provide the two power supply signals with different strengths. As noted before, the strength of a signal may be a power, an amplitude, a current level or a voltage level.

For instance, the power supply circuit 120 and the further power supply circuit 210 may be operable to provide their respective power supply signals on average with such a strength such that a ratio of the strength of the further power supply signal with respect to the strength of the power supply signal does not exceed 30:70. In other words, the two power supply circuits 120, 210 may be implemented in such a way that further power supply circuit 210 does not provide - on average - more than one third of the power supplied to the amplifying circuit 110. It should be noted that due to short-time variations, the previous limits may be exceeded during operation. For instance, additional energy may be taken from the inductive circuit element 130. Also on a short-time basis, the further power supply circuit 210 may provide more than the above-mentioned ratio concerning the strength of the two power supply signals.

Depending on the implementation and requirements of the amplifier circuit 100, the ratio of a strength of the further power supply signal and the power supply signal may not exceeding the ratio of 20:80, 10:90, 5:95or even 1:99 in other embodiments. Therefore, it may be possible to design the further power supply circuit 210 such that is capable of handling signals with an increased bandwidth. Naturally, it may be advisable, to restrict the ratio to values to be able to track the envelope signal more closely Otherwise, it might happen that the overall energy efficiency may drop again.

By limiting the strength of the power supply signal of the further power supply circuit 120, it may be possible to implement the further power supply circuit 210 more specifically designed to cope with the frequencies of the envelope signal ES. In return, the components of the further power supply circuit 210 may not be required to carry larger currents or cope with larger voltages. As a consequence, it may be possible to use components which are more suitable to higher frequencies, for instance, by limiting stray capacitances or other undesired parameters. In other words, by limiting the average of the strength of the further power supply signal with respect to the strength of the power supply signal, it may be possible to extend the overall bandwidth of the amplifier circuit 100 by providing a larger base portion of the energy required by the power supply circuit 120 covering lower frequency components, while the higher frequency components may be limited in terms of their strength.

To determine the strength of the power supply signal provided by the power supply circuit 120, the amplifier circuit 100 comprises a bias signal input terminal 220 coupled to a power supply circuit 120 over which a bias signal can be divided to the power supply circuit 120. Based on the bias signal, the power supply circuit 120 is capable of providing a power supply signal comprising a strength indicative of a strength of the bias signal.

As will be laid out in more detail below, the power supply circuit 120 comprises the previously mentioned controllable power supply circuit capable of controlling the strength of the power supply signal in response to the bias signal. The power supply circuit 120 may, for instance, comprise a controllable power supply circuit that in response to the previously mentioned control signal provides the power supply signal. The bias signal may then be added to the control signal such that the previously mentioned controllability of the strength of the power supply signal in response to the bias signal is achieved. The amplifier circuit 100 as shown in Fig. 1 further comprises a feedback control circuit 230 which is coupled to both, the power supply circuit 120 and the further power supply circuit 210. The feedback control circuit 230 is capable of detecting the strength of the further power supply signal and to provide a bias adjust signal to the power supply circuit 120 in response to a time-average of the detected strength of the further power supply signal. The bias adjust signal provided by the feedback control circuit 230 to the power supply circuit 120 is added to the control signal such that the bias adjust signal will have an influence on the power supply signal and its strength as provided by the power supply circuit 120.

However, the feedback control circuit 230 is based on using a time-averaged version of the detected strength of the further power supply signal to provide the bias adjust signal. The feedback control circuit 230 may be implemented to provide the bias adjust signal based on an averaging type lying in the range between 0.01 s and 100 s. In different embodiments, the averaging time may be in the range between 0.1 s and 10 s or even between 0.3 s and 4 s.

The feedback control circuit 230, therefore, allows a compensation of effects of drifts, changes of the operational parameters of the amplifier circuit 100 or other parameters on a larger time scale compared to the typical frequencies of the envelope signal and the short-time average as employed by the power supply circuit 120. For instance, by switching the amplifier circuit 100 into a different mode of operation requiring a lower energy by the amplifying circuit 110, the feedback control circuit 230 may detect that the strength of the further power supply signal decreases over the averaging time mentioned above. As a consequence, the feedback control circuit 230 provides the bias adjust signal in such a way that the power supply circuit 120 reduces the strength of the power supply signal to such an extent that the further power supply circuit 210 provides a further power supply signal with a strength responding to a pre-determined strength.

In the case of a switching into a mode of operation in which the amplifier circuit 100 consumes a larger amount of energy, the feedback control circuit 230 will detect that the strength of the further power supply signal exceeds its pre-determined value on average and, as a consequence, will generate a bias adjust signal imposed on the control signal for the controllable power supply circuit of the power supply circuit 120 in such a way that the strength of the further power supply signal will again decrease.

The feedback control circuit 230, therefore, forms a closed feedback loop to adjust on average the strength of the power supply signal such that the further power supply signal comprises a strength corresponding to a predetermined level.

As outlined before, the problem of improving the efficiency of a linear power amplifier has been addressed many times in the past in all fields where signal amplification is required. While many solutions have been found in the lower frequency end of the signal spectrum, for instance, in the field of audio amplifiers (e.g. class D amplifiers), for the specific case of microwave or radio-frequency power amplifier with very wideband modulating signals a fully satisfactory solution has not been found yet.

Considering, for instance, that microwave linear power amplifiers, sometimes also referred to as "µW PA", are generally operated with class A biasing and that in modem communication systems a peak-to-average power ratio (PAPR) of the modulated signal is very unfavorable, one can conclude that the power efficiency of a conventional microwave power amplifier stage is often very small. This, however, may lead to high power dissipation, thermal design problems, a reduced reliability and higher operating costs due to an increasing energy bill. For instance, in case of a n-level Quadrature Amplitude Modulation (n-QAM) or in the case of Orthogonal Frequency Division Multiplexing scheme (OFDM) a peak-to-average power ratio may even exceed 10 db.

Solutions to this problem have been proposed in the past based on different concepts. The more straight forward approach consists of applying a modulated supply of voltage to the microwave power amplifier stage, which follows the envelope of modulated signal to be transmitted. Examples of this conventional technique can be found widely in the literature. However, most of these techniques described fail to address the case where the bandwidth of the modulating signal is very wide, for instance, 30 MHz or more. This is the case, since the bandwidth of the supplied voltage to either circuit in these conventional approaches is inherently limited.

For example, some proposed techniques are based on PWM (pulse width modulation) switch-mode power convertors which control bandwidth can hardly reach the megahertz range. Therefore, approaches employing these techniques are typically not suitable for tracking the fast transient encountered in, for example, the envelope of a 28 MHz 128-QAM modulated signal.

Other techniques try to circumvent the bandwidth limitation of controlled-voltage power converters and are based on the concept of switching between a number of discrete power supply voltage levels. These techniques, however, typically also fail to reach high efficiencies when the modulated signal bandwidth is large because of the switching losses between the different supply rails and because of the limitations inherent with a limited number of discrete supply voltage levels.

To illustrate some limitations conventional approaches suffer from, Fig. 2 shows a circuit diagram of a part of a conventional amplifier circuit 300. The amplifier circuit 300 comprises a microwave power amplifier 310, which comprises a radio-frequency field effect transistor (RF FET) 320 with a gate terminal coupled to a terminal 330 to which a radio-frequency signal may be input (RF signal IN). A drain terminal of the radio-frequency field effect transistor 320 is coupled to an output terminal (RF OUT) 340 at which the amplified radio-frequency signal provided to terminal 330 may be obtained. The drain terminal of the radio-frequency field effect transistor 320 is coupled to a node 350 to which an output of a driver amplifier 360, and via an inductor 370, a terminal 380 for a constant power supply is connected. However, the constant power supply is not shown in Fig. 2.

A control terminal 390 of the driver amplifier 360 is coupled to an envelope detector (not shown in Fig. 2) to provide the driver amplifier 360 with an envelope signal. The driver amplifier 360 is furthermore coupled to a terminal 400 to which a further constant power supply is connected. The further constant power supply provides the amplifier circuit 300 with a constant voltage V₂, while the constant power supply circuit coupled to terminal 380 provides the amplifier circuit 300 with a voltage V₁ typically lower than the voltage V₂. Due to the applied voltages and the envelope signal provided to the control terminal 390, the amplifier 360 causes a current I₂ to flow into a node 350 to which a constant voltage V₁ of the constant power supply circuit provides a current I₁ via the inductor 370 (inductance L). Both currents add up at node 350 to form a bias current I_{Bias} flowing through the radio-frequency field effect transistor 320. A source terminal of the radio-frequency field effect transistor 320 is coupled to a reference potential (e.g. ground).

The amplifier circuit 300 as shown in Fig. 2 may be adjusted in terms of the voltages supplied and other parameters such that the supplied voltage delivered to the microwave power amplifier 310 is taken for the most part from the lower voltage power supply coupled to terminal 380. Only a minor corrective term is drawn from the higher voltage power supply to terminal 400 through the driver amplifier 360. This approach reduces the overall power dissipation as compared to other conventional techniques. However, as the following brief discussion will show, the reference implementation as shown in Fig. 2 cannot prove any method for controlling the exact amount of current actually flowing through the inductor 370. The inductor 370 is in this implementation mainly used as a substitute for a blocking diode in order to eliminate the associated switching losses. In other words, the inductor 370 is to prevent the current I2 from flowing from the supply coupled to terminal 400 back into the supply coupled to terminal 380.

Moreover, the supply voltage V₁ is fixed and is, therefore, not adapted to the varying signal level conditions induced by different operating modes of the device comprising the amplifier circuit 300. For instance, in the case of a radio transmitter varying signal level conditions may be caused by an adapted modulation or an automatic transmission power control.

As a consequence, the inductor 370 will form the average voltage at the drain terminal of the radio-frequency field effect transistor 320 to be exactly equal to the fixed voltage value V₁ provided to the terminal 380, regardless of the actual shape and mean level of the radio-frequency signal analog provided to the control terminal 390. This may lead to a loss of efficiency, which can be significant under some circumstances.

Another consequence of not being able to precisely control the amount of current I₁ flowing through the inductor 370 from the constant power supply coupled to terminal 380 is that the driver amplifier 360, which is connected to the constant power supply coupled to terminal 400, should be designed to sustain the entire supply current drawn by microwave power amplifier 310 and its radio-frequency field effect transistor 320. This restricts the selection of the driver amplifier components to high-current devices with large inter-electrode capacitances that will limit the maximum obtainable bandwidth of the driver amplifier 360. The reference implementation shown in Fig. 2, therefore, clearly shows at least some areas where improvements are possible. As compared to the amplifier circuit 100 according to an embodiment as shown in Fig. 1, the amplifier circuit 300 as shown in Fig. 2 suffers from some limitations.

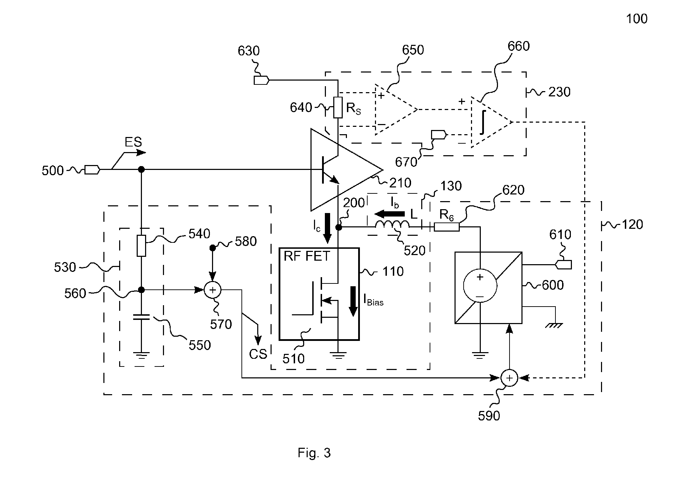

Fig. 3 shows a circuit diagram of a part of the amplifier circuit 100 as depicted in Fig. 1. Fig. 3 once again shows the amplifying circuit 110 coupled via the further node 200 to the power supply circuit 120 via the inductive circuit element 130 and the further power supply circuit 210. Moreover, Fig. 3 also shows the feedback control circuit 230 being coupled to both the power supply circuit 120 and the further power supply circuit 210.

However, for the sake of simplicity, the envelope detector 140 as well as the input terminal 150 for the intermediate frequency, the up-converter 160, the local oscillator 170, the output terminal 180 for amplified radio-frequency signal ARF have been omitted. To be more precise, the output terminal 180 may be directly coupled to the further node 200 between the inductor circuit element 130, the further power supply circuit 210 and the amplifying circuit 110. Instead of the envelope detector 140, the circuit shown in Fig. 2 comprises a terminal 500 for the envelope signal ES, which is coupled to the control input of the further power supply circuit 210 and a corresponding terminal of the power supply circuit 120.

The amplifier circuit 100 as shown in Fig. 3 is a microwave amplifier circuit. Microwave frequencies are typically in the range between 300 MHz and 300 GHz. However, in the having a specific application in mind, a band of this frequency range may be chosen. For instance, in the case of mobile communication systems, typically a frequency band somewhere between 400 MHz and 5 GHz is used. In microwave transmissions, typically frequencies of roughly 1 GHz to approximately 50 GHz are used. Naturally, an amplifier circuit 100 according to an embodiment is by far not required to cope with the whole range of the frequencies mentioned. It is merely sufficient to be used in a limited frequency band of the frequencies mentioned above. Accordingly, the amplifying circuit 110 is implemented as a microwave power amplifier comprising a radio-frequency field effect transistor (RF FET) 510. As already shown in the context of Fig. 2, the radio-frequency signal is provided to a gate terminal of the radio-frequency field effect transistor 510. While a source terminal of the radio-frequency field effect transistor 510 is coupled to a reference potential (e.g. ground), its drain terminal is coupled to the further node 200.

The inductive circuit element 130 is implemented as an inductor 520 with an inductance value L somewhere in the range between 0.1 µH to 50 µH. In different embodiments, values of approximately 1 µH to approximately 20 µH may be used.

As already previously described in the context of Fig. 1, the power supply circuit 120 is operable to provide a bulk current I_{b} flowing through the inductor 520 into node 200. The further power supply circuit 210, which may be implemented as a driver amplifier, typically provides a lower current I_{c}, which is also referred to as the correction current. Though, the bulk current I_{b} and the correction current I_{c} are added at the further node 200 and provided to the radio-frequency field effect transistor 510 of the amplifier circuit 100 to form the bias current I_{Bias} which is - on average - essentially constant due to the interactions of power supply circuit 120 and the further power supply circuit 210.

To illustrate this in more detail, the power supply circuit 120 comprises a low-pass filter 530, which is coupled to the terminal for the envelope signal 500. The low-pass filter 530 comprises series connection of a resistor 540 and a capacitor 450. The resistor 540 is coupled to the terminal 540 for the envelope signal and to a node 560 in between the resistor 540 and the capacitor 550. Apart from the node 560, the capacitor 550 is also coupled to the reference potential (e.g. ground). As outlined before, the low-pass filter is designed such that it is able to provide a short-time average of the envelope component as comprised in the envelope signal ES with one of the previously mentioned time-bandwidth-product. To achieve this, node 560 is coupled to an input of a first adder 570. A further input of the first adder 570 is coupled to an input terminal 580 for the bias signal to control the current provided by the power supply circuit 120 to the amplifying circuit 110 via the inductive circuit element 130.

To be more precise, in the present implementation as shown in Fig. 3, the first adder 570 is implemented as a voltage adding circuit. As a consequence, an offset control voltage level may be applied to the input terminal 580 which is then added to a voltage level obtained at node 560 to obtain the control signal CS. Hence, the control signal CS comprises a voltage level which is indicative of a sum of an average envelope voltage and offset control voltage level provided to the input terminal 580.

At an output of the first adder 570, the control signal CS is provided to an optional second adder 590. An output of the second adder 590 is then provided to control input of a controllable power supply circuit 600. The controllable power supply circuit 600 may be implemented, for instance, as at least one of a switch-mode power supply circuit, a DC/DC-converter and a step-down converter. The controllable power supply circuit 600 is coupled to the reference potential (e.g. ground) and - in the implementation shown in Fig. 3 - to a further reference potential, in this case a chassis ground. The controllable power supply circuit 600 is further coupled to a terminal 610 to which the voltage Vₚᵣᵢₘ can be provided. To be more precise, the controllable power supply circuit 600 is a controlled DC/DC-converter providing at an output a voltage V₁ which can be controlled by the voltage provided to its control input. Naturally, the two adders 570, 590 may be implemented as a single adder.

The power supply circuit 120 further comprises an output resistor 620, which is coupled to the output of the controllable power supply circuit 600. The output resistor 620 comprises a resistance value R_{b} which enables along with the offset control voltage level provided to input terminal 580 to define an inductive current to the output by the power supply circuit 120. To be more precise, by applying an offset control voltage level I_{b} · R_{b} to the input terminal 580 and the bias signal - on average - a current I_{b} will be provided by the power supply circuit 120 to the inductive circuit element 130. Hence, the controllable power supply circuit 600 is operable to control a strength of the power supply signal in response to the bias signal provided to the input terminal 580.

The amplifier circuit 100 further comprises an auxiliary terminal 630 to which the power supply with a voltage level Vₐᵤₓ may be applied by a suitable power supply. The auxiliary terminal 630 is coupled to the feedback control circuit 230 and a sensing resistor 640 comprising a resistance value Rₛ. The sensing resistor 640 is furthermore coupled to an input of the further power supply circuit 210 which is also referred to as the driver amplifier.

The sensing resistor 640 is used by the feedback control circuit 230 to determine the amount of the correction current I_{c} - in other words - the strength of the further power supply signal. To avoid interferences with other parts of the circuit, the feedback control circuit 230 further comprises a follower or a buffer 650 to electrically decouple the rest of the feedback control circuit from the input of the further power supply circuit 210. An output of the buffer 650 is coupled to an integrator 660, which is also provided via a set terminal 670 with a reference signal indicative of an intended magnitude of the correction current I_{c}.

An output of the integrator 660 is then coupled to an input of the second adder 590. In case the detected control current I_{c} deviates from the value indicated by the exact signal provided to the set terminal 670 over a longer period of time, the integrator 660 will provide a bias point adjust signal to the second adder 590 forming a bias point adjust loop to adjust the bulk current I_{b} in response to the deviation. The bulk current I_{b} is in the present case the strength of the power supply signal as provided by the power supply circuit 120.

The amplifier circuit 100 as shown in Figs. 1 and 3 therefore is based on the basic idea for an improved solution such that the supply voltage V₁ can be controlled in such a way that it - on average - tracks the short-term average of the modulated signal envelope. By doing so, the voltage level at the two terminals of the inductor 520 will be - on average - equal, making it possible to stay in a constant current flow from the power supply circuit 120 to the amplifying circuit 110 forming the loop of the power supply circuit 120. This can be achieved due to the control established essentially independently of large voltage excursions that may appear at the drain terminal of the microwave or radio-frequency power amplifier field effect transistor 510. Being able to apply a large and fast variation of the supply voltage of the field effect transistor 510 is one key factor for improving the power efficiency of the microwave power amplifier 110.

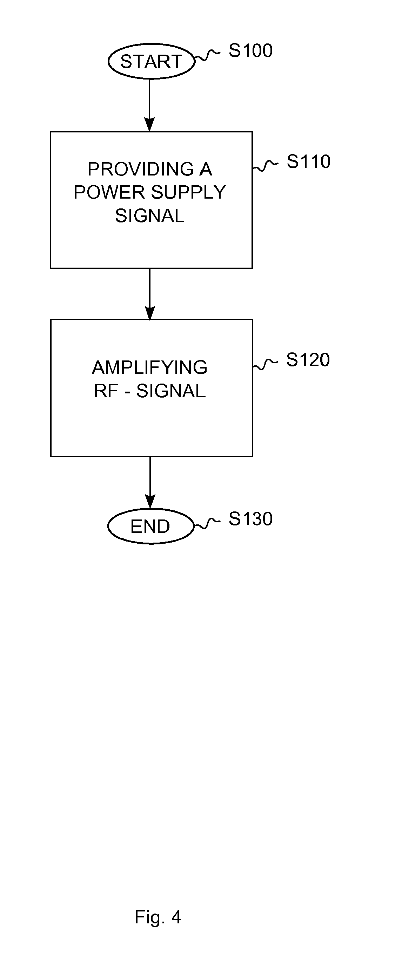

Moreover, by taking the envelope signal ES and information concerning the envelope component of the radio-frequency signal comprised therein into account, the presented embodiment and the respective methods, which will be described in more detail in Fig. 4, may allow the value of the main supply voltage V₁ to automatically adapt to varying characteristics of the modulated signal envelope. This may, for instance, lead to a decreased power consumption in the case that an automatic TX power control algorithm is used by a radio system comprising the amplifier circuit 100 according to an embodiment, since when the transmission power is commanded to decrease, the control signal supplied to the controllable power supply circuit 600 will also decrease. As outlined, the power consumption of the microwave power amplifier stage will decrease.

Seen from another perspective, the solution described may be regarded eventually as a method for implementing a very fast continuously-variable regulated supply voltage converter with low or minimal conversion losses, without the bandwidth limitations associated with conventional PWM switch-mode regulators and without the losses as typically associated with switch supply techniques which are also known as class G amplifiers.

The microwave power amplifier field effect transistor 510 is biased with an approximately constant supplied current I_{Bias} that is provided as a sum of the two components previously described. A slowly varying bulk current I_{b} sourced through a large valued inductor L is provided from a low-voltage controlled power supply circuit 120. Moreover, a rapidly varying correction current I_{c} sourced through a linear driver amplifier (further power supply circuit 210). The high-voltage auxiliary power supply terminal 630 is added to the bulk current I_{b}.

The correction current I_{c} (further power supply signal) sourced by the driver amplifier is - on average - controlled in such a way that it constitutes only a small fraction of the overall microwave power amplifier bias current, while the large part of the supply current is sourced from the low-voltage main power converter (controllable power supply circuit 600).

The linear driver amplifier is driven by a signal that is proportional to the envelope of the modulated radio-frequency signal. It will, therefore, force the supply voltage of the microwave power amplifier to follow the envelope of the modulated radio-frequency signal, even above the main supply voltage V₁, up to the value of the auxiliary supply voltage Vₐᵤₓ. Therefore, the desired reduction of power consumption may be realized without essentially compromising the dynamic range and linearity characteristics of the microwave power amplifier.

The output voltage of a main power converter V₁ is controlled in such a way as to essentially replicate the short-time average of the envelope of the modulated radio-frequency signal. In other words, the average value of the power amplifier supply voltage is controlled by the auxiliary driver amplifier to exactly replicate the short-time average of the envelope of the modulated radio-frequency signal.

The controlled bandwidth of the adjustable main power converter (power supply circuit 120 or controllable power supply circuit 600) does not need to be very large, as only the average level of the envelope signal ES is tracked. Response times in the millisecond range are often acceptable leading to frequencies of 1 - 7 kHz concerning the bulk currency I_{b} (power supply signal). As a consequence, the conventional power supply architecture may be used as described.

Due to the regulation performed on a supply voltage V₁ backing the short-time average of the envelope signal ES, the average value of the voltage across the inductor 520 is approximately zero. Therefore, in principle, any arbitrary current value could ideally be sustained through the inductor 520 in a steady state condition. By supplying the bias signal to the input terminal 580, it is intended to set the bulk current I_{b} through the inductor 520 such as to provide the most part of the microwave power amplifier bias current. As outlined before, the ratio of the correction current I_{c} with respect to the bulk currents I_{b} may be lower than 30:70, 20:80, 10:90, 5:95 or even 1:99. In other words, only a minor part of current I_{Bias} through the radio-frequency field effect transistor 510 is provided by the further power supply circuit 210.

### !js!

As indicated earlier, the desired value of the bulk current I_{b} flowing through the inductor 520 can be controlled by means of the small series ballast resistor or output resistor 620 having the resistance value R_{b} and by applying the a small voltage offset V_{b} = I_{b '} R_{b} to the main supply voltage V₁ of the controllable power supply circuit 600. By properly selecting the offset control voltage level V_{b}, it is possible to control the ratio between the bulk current I_{b} and the correction current I_{c} applied to the radio-frequency field effect transistor 510. It is to be noted that the voltage wave form at the power amplifier supply terminal in other words, the further node 200 or the drain terminal of the radio-frequency field effect transistor 510, will always exactly follow the desired envelope wave form, even when it drops below the main supply voltage V₁. In this case, the inductor 520 is still forcing the current to the low (radio-frequency field effect transistor 510).

As outlined before, an additional adjustment control loop can optionally be added in order to compensate component tolerances and fluctuations of the temperature and aging. The addition feedback control circuit 230 ensures that the ratio between the bulk current and the correction current I_{b}/I_{c} will remain stable across the full equipment operating range. The adjustment loop comprising the feedback control circuit 230 senses the average value of the correction current I_{c} from the auxiliary supply terminal 630 and produces a small adjustment voltage that is added to the control signal of the main supply voltage V₁. For its very nature, the response times of the bias point adjustment loop is generally rather slow, often in the order of seconds.

Fig. 4 shows a flow chart of an embodiment of a method for amplifying a modulated radio-frequency signal comprising a radio-frequency component and an envelope component. After a start of the method in step S100, in a step S110, a power supply signal is provided via the inductive circuit element 130 shown in Figs. 1 and 3. The power supply signal is based on the envelope component and suppressed radio-frequency component of the modulated radio-frequency signal to be amplified as outlined before. In a step S120, radio-frequency signal is amplified using the power supply signal provided in step S110. Afterwards, in the step S130 the embodiment ends.

Naturally, although in Fig. 4 the steps S110 and S120 are shown in a consecutive order, the steps S110 and S120 are typically performed simultaneously. However, depending on the circumstances, the complete sequential performance of the previously mentioned step can equally well be implemented according to an embodiment.

As the previous discussion has shown, the embodiment provides a method for improving the efficiency of microwave power amplifiers with envelope-modulated supply voltages. Using an amplifier circuit 100 according to an embodiment may help to reduce the power consumption of a microwave power amplifier, even when the bandwidth of the modulated signal to be transmitted is large, such as 30 MHz or more. A reduced power consumption enables a simpler thermal design and might bring benefits to the equipment operating because of the reduced energy bill.

An amplifier circuit according to an embodiment may, for instance, be beneficially applied in transmission systems, where the bandwidth of the modulated signal is very wide, whereas most of the existing solutions start to lose their efficiency at much smaller bandwidths.

Compared to the more conventional approach as depicted in Fig. 2, the amplifier circuit according to an embodiment typically provides a higher conversion efficiency that - according to simulations - can yield a further power saving of up to 25 %. This may be obtained by optimizing the value of the main supply voltage V₁ as provided by the power supply circuit 120. In addition, an embodiment of an amplifier circuit may be able to automatically adapt to the varying signal conditions encountered in, for instance, adaptive modulation systems or automatic transmission power control (ATPC) loops. More specifically, an embodiment of an amplifier circuit or the corresponding method may be able to decrease the power amplifier power consumption when the transmitted signal power is decreased in contrast, for instance, to the reference implementation shown in Fig. 2.

Since power reduction techniques are gaining considerable attention in the last years, employing energy saving techniques in the field of developing transmission equipment is becoming more and more important. For instance, taking the growing green environmental awareness into consideration, employing energy-efficient techniques becomes more and more important in many fields and relevant international standards, such as the CE, the CENELEC, the ETSI and other standards.

Embodiments may offer the possibility of improving a power reduction that is able to work on very wide band radio-frequency channels and/or to adapt to varying transmission signal conditions. Moreover, it may be possible to implement an embodiment very efficiently, since - as the previous description of embodiments has shown - amplifier circuits 100 according to an embodiment offer a great simplicity and, hence, low costs in terms of implementation.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

Functional blocks denoted as "means for ..." (performing a certain function) shall be understood as functional blocks comprising circuitry that is adapted for performing a certain function, respectively. Hence, a "means for s.th." may as well be understood as a "means being adapted or suited for s.th.". A means being adapted for performing a certain function does, hence, not imply that such means necessarily is performing said function (at a given time instant).

Functions of various elements shown in the figures, including any functional blocks may be provided through the use of dedicated hardware, as e.g. a processor, as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and nonvolatile storage. Other hardware, conventional and/or custom, may also be included.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

Furthermore, the following claims are hereby incorporated into the Detailed Description, where each claim may stand on its own as a separate embodiment. While each claim may stand on its own as a separate embodiment, it is to be noted that - although a dependent claim may refer in the claims to a specific combination with one or more other claims - other embodiments may also include a combination of the dependent claim with the subject matter of each other dependent claim. Such combinations are proposed herein unless it is stated that a specific combination is not intended. Furthermore, it is intended to include also features of a claim to any other independent claim even if this claim is not directly made dependent to the independent claim.

It is further to be noted that methods disclosed in the specification or in the claims may be implemented by a device having means for performing each of the respective steps of these methods.

Further, it is to be understood that the disclosure of multiple steps or functions disclosed in the specification or claims may not be construed as to be within the specific order. Therefore, the disclosure of multiple steps or functions will not limit these to a particular order unless such steps or functions are not interchangeable for technical reasons. Furthermore, in some embodiments a single step may include or may be broken into multiple sub steps. Such sub steps may be included and part of the disclosure of this single step unless explicitly excluded.

## Claims

1. An amplifier circuit (100) for amplifying a modulated radio-frequency signal (RF) comprising a radio-frequency component and an envelope component, comprising:
an amplifying circuit (110) operable to amplify the radio-frequency signal (RF);
a power supply circuit (120) coupled to the amplifying circuit (110) to provide a power supply signal to the amplifying circuit (110); and
an inductive circuit element (130) coupled between the amplifying circuit (110) and the power supply circuit (120),
wherein the power supply circuit (120) is operable to provide the power supply signal based on the envelope component and a suppressed radio-frequency component.

2. The amplifier circuit (100) according to claim 1, wherein the power supply circuit (120) is operable to provide the power supply signal based on an average of the envelope component.

3. The amplifier (100) circuit according to claim 2, wherein the power supply circuit (120) is operable to provide the power supply signal based on a short-time average of the envelope component with a time-bandwidth-product between 10² and 10⁶_{.}

4. The amplifier (100) circuit according to claim 1, wherein the power supply circuit (120) comprises a controllable power supply circuit (600) operable to provide the power supply signal in response to a control signal (CS), wherein the power supply circuit (120) further comprises a low-pass filter (530) operable to receive an envelope signal (ES) indicative of the envelope component, wherein the low-pass filter (530) is further operable to provide the control signal (SC) by low-pass filtering the envelope signal (ES).

5. The amplifier circuit (100) according to claim 4, wherein the controllable power supply circuit (120) comprises at least one of a switched-mode power supply circuit, a DC/DC-converter, and a step-down converter.

6. The amplifier (100) circuit according to claim 1, wherein the power supply circuit (120) is operable to provide the power supply signal as a continuously valued signal.

7. The amplifier (100) circuit according to claim 4, wherein the power supply circuit (120) is operable to add a bias signal to the control signal (CS), and wherein the controllable power supply circuit (600) is operable to control a strength of the power supply signal in response to the bias signal.

8. The amplifier circuit (100) according to claim 7, wherein the strength of the power supply signal is a current level of the power supply signal, wherein the bias signal comprises an offset control voltage level, wherein the power supply circuit (120) comprises an output resistor (620) coupled between an output of the controllable power supply circuit (600) and the inductive circuit element (130), the output resistor (620) comprising a resistance value such that the controllable power supply circuit (120) is operable to provide a predefined current level of the power supply signal based on a ratio of the offset control voltage level and the resistance value of the output resistor (620).

9. The amplifier circuit (100) according to claim 1, further comprising a further power supply circuit (210) coupled to the amplifying circuit (110) and operable to provide a further power supply signal to the amplifying circuit (110) based on the envelope component.

10. The amplifier circuit (100) according to claim 9, wherein the further power supply circuit (210) and the power supply circuit (120) are operable to provide on average a strength of the further power supply signal and of the power supply signal, respectively, comprising a ratio of not more than 30:70.

11. The amplifier circuit (100) according to claim 9, further comprising a feedback control circuit (230) operable to detect a strength of the further power supply signal and to provide a bias adjust signal to the power supply circuit (120) in response to a time-average of the detected strength of the further power supply signal, wherein the power supply circuit (120) comprises a controllable power supply circuit (600) operable to provide the power supply signal in response to a control signal (CS), and wherein the power supply circuit (120) is operable to add the bias adjust signal to the control signal.

12. The amplifier circuit (100) according to claim 11, wherein the feedback control circuit (230) is operable to provide the bias adjust signal based on an averaging time between 0.01 s and 100 s.

13. The amplifier circuit (100) according to claim 1, wherein the amplifier circuit (100) is a microwave amplifier circuit, and wherein the amplifying circuit (110) is a microwave amplifying circuit.

14. A method for amplifying a modulated radio-frequency signal (RF) comprising a radio-frequency component and an envelope component, comprising:
providing (S110) a power supply signal via an inductive circuit element (130), wherein the power supply signal is based on the envelope component and a suppressed radio-frequency component of the modulated radio-frequency signal (RF); and
amplifying (S120) the radio-frequency signal using the power supply signal.

15. A computer program comprising a program code for performing the method of claim 14, when the computer program is executed on a computer or a processor.

## Amended claims

### Amended claims in accordance with Rule 137(2) EPC.

**1.** An amplifier circuit (100) for amplifying a modulated radio-frequency signal (RF) comprising a radio-frequency component and an envelope component, comprising:
an amplifying circuit (110) operable to amplify the radio-frequency signal (RF);
a power supply circuit (120) coupled to the amplifying circuit (110) to provide a power supply signal to the amplifying circuit (110);
an inductive circuit element (130) coupled between the amplifying circuit (110) and the power supply circuit (120);
a further power supply circuit (210) coupled to the amplifying circuit (110) and
operable to provide a further power supply signal to the amplifying circuit (110) based on the envelope component; and
a feedback control circuit (230) operable to detect a strength of the further power supply signal and to provide a bias adjust signal to the power supply circuit (120) in response to a time-average of the detected strength of the further power supply signal,
wherein the power supply circuit (120) is operable to provide the power supply signal based on the envelope component and a suppressed radio-frequency component; and
wherein the power supply circuit (120) comprises a controllable power supply circuit (600) operable to provide the power supply signal in response to a control signal (CS), and wherein the power supply circuit (120) is operable to add the bias adjust signal to the control signal.

**2.** The amplifier circuit (100) according to claim 1, wherein the power supply circuit (120) is operable to provide the power supply signal based on an average of the envelope component.

**3.** The amplifier (100) circuit according to claim 2, wherein the power supply circuit (120) is operable to provide the power supply signal based on a short-time average of the envelope component with a time-bandwidth-product between 10² and 10⁶.

**4.** The amplifier (100) circuit according to claim 1, wherein the power supply circuit (120) comprises a controllable power supply circuit (600) operable to provide the power supply signal in response to a control signal (CS), wherein the power supply circuit (120) further comprises a low-pass filter (530) operable to receive an envelope signal (ES) indicative of the envelope component, wherein the low-pass filter (530) is further operable to provide the control signal (CS) by low-pass filtering the envelope signal (ES).

**5.** The amplifier circuit (100) according to claim 4, wherein the controllable power supply circuit (120) comprises at least one of a switched-mode power supply circuit, a DC/DC-converter, and a step-down converter.

**6.** The amplifier (100) circuit according to claim 1, wherein the power supply circuit (120) is operable to provide the power supply signal as a continuously valued signal.

**7.** The amplifier (100) circuit according to claim 4, wherein the power supply circuit (120) is operable to add a bias signal to the control signal (CS), and wherein the controllable power supply circuit (600) is operable to control a strength of the power supply signal in response to the bias signal.

**8.** The amplifier circuit (100) according to claim 7, wherein the strength of the power supply signal is a current level of the power supply signal, wherein the bias signal comprises an offset control voltage level, wherein the power supply circuit (120) comprises an output resistor (620) coupled between an output of the controllable power supply circuit (600) and the inductive circuit element (130), the output resistor (620) comprising a resistance value such that the controllable power supply circuit (120) is operable to provide a predefined current level of the power supply signal based on a ratio of the offset control voltage level and the resistance value of the output resistor (620).

**9.** The amplifier circuit (100) according to claim 1, wherein the further power supply circuit (210) and the power supply circuit (120) are operable to provide on average a strength of the further power supply signal and of the power supply signal, respectively, comprising a ratio of not more than 30:70.

**10.** The amplifier circuit (100) according to claim 1, wherein the feedback control circuit (230) is operable to provide the bias adjust signal based on an averaging time between 0.01 s and 100 s.

**11.** The amplifier circuit (100) according to claim 1, wherein the amplifier circuit (100) is a microwave amplifier circuit, and wherein the amplifying circuit (110) is a microwave amplifying circuit.

**12.** A method for amplifying a modulated radio-frequency signal (RF) comprising a radio-frequency component and an envelope component, comprising:
providing (S110) a power supply signal via an inductive circuit element (130),
wherein the power supply signal is based on the envelope component and a suppressed radio-frequency component of the modulated radio-frequency signal (RF) in response to a control signal (CS);
providing a further power supply signal based on the envelope component to amplify the the radio-frequency signal;
detecting a strength of the further power supply signal;
providing a bias adjust signal in response to a time-average of the detected strength of the further power supply signal, and
amplifying (S120) the radio-frequency signal using the power supply signal,
wherein providing (S110) a power supply signal comprises adding the bias adjust signal to the control signal.

**13.** A computer program comprising a program code for performing the method of claim 12, when the computer program is executed on a computer or a processor.
